Europäisches Patentamt

(19) European Patent Office

Office européen des brevets

(11) Publication number: 0 163 368

A1

(12) **EUROPEAN PATENT APPLICATION**

(21) Application number: 85301560.0

(22) Date of filing: 07.03.85

(51) Int. Cl.⁴: **H 01 L 21/48**
H 01 L 27/01, C 04 B 37/02
C 04 B 41/90

(30) Priority: 28.03.84 GB 8407944

(43) Date of publication of application:
04.12.85 Bulletin 85/49

(84) Designated Contracting States:
BE DE FR IT LU NL

(71) Applicant: PLESSEY OVERSEAS LIMITED
Vicarage Lane
Ilford Essex IGI 4AQ(GB)

(72) Inventor: Stanley, Antony
5 Helston Drive
Emsworth Hants(GB)

(72) Inventor: Bilson, Robert
18 Balmoral Close
Towcester Northants(GB)

(74) Representative: Fish, Norman Ernest
The Plessey Company plc Intellectual Property
Department Vicarage Lane
Ilford Essex IG1 4AQ(GB)

(54) Through hole interconnections.

(57) A method of producing a through hole interconnection
which extends through a hole formed in a ceramic substrate
carrying a thick film circuit, comprising introducing within
the hole a glass/ceramic paste, heating the glass/ceramic
paste to produce withint he hole an annulus of fused
glass/ceramic (8), introducing within the annulus a copper
paste, and heating the copper paste to produce on the
surface of the annulus a copper layer (9) which extends
between opposing sides of the substrate to provide a
through hole interconnection.

FIG.2.

EP 0 163 368 A1

# THROUGH HOLE INTERCONNECTIONS

This invention relates to a method of producing through hole interconnections in ceramic substrates carrying thick film circuits.

Known through hole interconnection techniques comprise the use of a gold or copper paste which is fused to define a tubular conductor on the wall of a hole formed in a ceramic substrate by laser drilling, or press piercing, thereby to interconnect conductive pads of a thick film circuit on opposing sides of the substrate.

In order to produce low cost thick film circuits on ceramic substrates it is necessary to use an inexpensive through hole interconnection technique, especially where a large number of through hole interconnections are required to be made. Although gold or copper can be used to produce through hole intercconections, in view of the price advantage, it is preferable to use a copper paste rather than a gold paste. If however holes are formed in the ceramic substrate by means of a laser drilling technique, a glassing effect is produced in and around the holes which adversely affects metal adhesion and generally obviates the use of copper pastes in particular and therefore restricts the choice to expensive gold paste.

Instead of using a laser drilling technique, holes may alternatively be formed in ceramic substrates by press piercing methods. Press piercing however has the disadvantage that holes thus formed can have sharp or irregular edges which affect the reliability of through hole connections. Thus pressed pierced holes must be smoothed as by means of sand blasting which is an expensive and dirty additional process step.

It is an object of the present invention to provide a method of producing reliable through hole interconnections inexpensively in ceramic substrates carrying thick film circuits.

According to the present invention a method of producing a through hole interconnection which extends through a hole formed in a ceramic substrate carrying a thick film circuit, comprises introducing within the hole a glass/ceramic paste, heating the glass/ceramic paste to produce within the hole an annulus of fused glass/ceramic, introducing within the annulus a copper paste, and heating the copper paste to produce on the surface of the annulus a copper layer which extends between opposing sides of the substrate to provide a through hole interconnection.

The glass/ceramic paste may be fused in air.

The copper paste may be fused in nitrogen.

The glass/ceramic paste may a proprietary paste sold under the trade name Engelhard 33/370A.

The copper paste may be a proprietary paste sold

0163368

under the trade name Dupont 9922.

The glass/ceramic paste may be fused by heating for approximately 37 minutes at about 900°C.

The copper paste may be fused by heating for approximately 50 minutes at about 900°C.

One embodiment of the invention will now be described by way of example with reference to the accompanying drawings in which:

Figure 1 is a plan view of a thick film circuit carried by a ceramic substrate; and,

Figure 2 is a sectional side view of the substrate of Figure 1 showing a through hole interconnection.

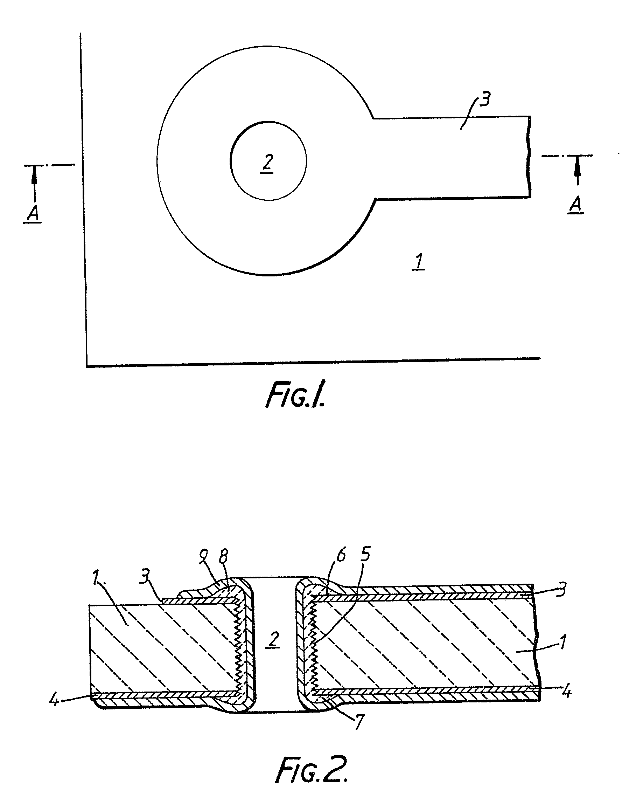

Referring now to the drawing, wherein corresponding parts of Figure 1 and Figure 2 bear as appropriate the same numerical designations, a ceramic substrate 1 is pierced to define a hole 2 which extends therethrough between on one side a thick film circuit conductor 3 and on the other side thereof a conductive ground plane 4. The hole 2 may be formed by a laser drilling technique or alternatively by a press piercing method. Press piercing is probably less expensive and therefore preferable. If the hole 2 is formed by press piercing however, a rough inside wall 5 is produced which is not ideal for receiving a metal coating. In order to prepare the wall 5 so as to provide a suitable surface for receiving a conductive material, the surface 5 and opposing annular regions 6 and 7 around the hole 2 are coated in a glass ceramic paste such as the glass ceramic paste commercially available under the trade name Engelhard 33/370A. The glass/ceramic paste coating is then fused at a temperature of 900°C for about 37 minutes in air to produce a generally annular fused glass/ceramic coating 8 within the hole 2.

In order to form on the fused glass/ceramic coating 8 a conductive layer, the coating 8 is first covered with a copper paste such as a copper paste which is commercially available under the trade name Dupont 9922. The copper paste is fused by heating to a temperature of about 900°C for about 50 minutes in nitrogen. This produces a copper interconnection region 9 which extends through the hole 2 to define an annular layer which interconnects the thick film circuit conductor 3 and the conductive ground plane 4 which are disposed on opposing sides of the substrate 1.

Various modifications may be made to the method hereinbefore described without departing from the scope of the invention and for example any suitable copper or glass/ceramic paste may be used and the hole may be formed by any suitable alternative hole forming technique.

NEF/TFS

0163368

## CLAIMS:

1. A method of producing a through hole interconnection which extends through a hole formed in a ceramic substrate carrying a thick film circuit, comprising introducing within the hole a glass/ceramic paste, heating the glass/ceramic paste to produce within the hole an annulus of fused glass/ceramic, introducing within the annulus a copper paste, and heating the copper paste to produce on the surface of the annulus a copper layer which extends between opposing sides of the substrate to provide a through hole interconnection.

2. A method as claimed in claim 1 wherein the glass/ceramic paste is fused in air.

3. A method as claimed in claim 1 or claim 2 wherein the copper paste is fused in nitrogen.

4. A method as claimed in any preceding claim where the glass/ceramic paste is a proprietary paste sold under the trade name Engelhard 33/370A.

5. A method as claimed in any preceding claim wherein the copper paste is a proprietary paste sold under the trade name Dupont 9922.

6. A method as claimed in any preceding claim wherein the glass/ceramic paste is fused by heating for approximately 37 minutes at about 900°C.

7. A method as claimed in any preceding claim wherein the copper paste is fused by heating for approximately 50 minutes at about 900°C.

8. A circuit carrying substrate comprising at least one through hole interconnection produced by a method as claimed in any preceding claim.

9. A circuit carrying substrate produced by a method as claimed in any preceding claim and substantially as hereinbefore described with reference to the accompanying drawing.

0163368

1/1

FIG.1.

FIG.2.

European Patent Office

**EUROPEAN SEARCH REPORT**

. Application number

EP 85 30 1560

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | EP-A-0 063 843 (TELECOMMUNICATIONS RADIOELECTRIQUES ET TELEPHONIQUES) * Claim 1 * | 1 | H 01 L 21/48 H 01 L 27/01 C 04 B 37/02 C 04 B 41/90 |
| | --- | | |
| A | EP-A-0 093 633 (THOMSON-CSF) * Page 3, lines 4-34 * | 1 | |
| | --- | | |
| A | SOLID-STATE TECHNOLOGY, vol. 23, no. 10, October 1980, Port Washington, USA; D.E. PITKANEN et al. "Status of Copper Thick Film Hybrids", pages 141-146 * Page 142, paragraph 1 * | 1,7 | |
| | ----- | | |

**TECHNICAL FIELDS SEARCHED (Int. Cl.4)**

C 04 B 37/02
C 04 B 41/00
H 01 L 21/48
H 01 L 21/70
H 01 L 27/01
H 05 K 3/42

The present search report has been drawn up for all claims

| Place of search | Date of completion of the search | Examiner |
|---|---|---|
| BERLIN | 24-06-1985 | GIBBS C.S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82